# EUROPÄISCHE PATENTSCHRIFT

(11) **EP 1 573 829 B1**
(45) Veröffentlichungstag und Bekanntmachung des Hinweises auf die Patenterteilung: **19.03.2008**
(21) Anmeldenummer: 03788806.2
(22) Anmeldetag: 21.11.2003
(51) Int. Cl.: H01L 47/02

(54) **GUNN-DIODE**
GUNN DIODE
DIODE GUNN

(30) Priorität: 20.12.2002 DE 10261238
(43) Veröffentlichungstag der Anmeldung: 14.09.2005
(73) Patentinhaber: Forschungszentrum Jülich GmbH, 52425 Jülich (DE)
(72) Erfinder: FÖRSTER, Arnold, 52152 Simmerath (DE); LEPSA, Mihail, Ion, 52428 Jülich (DE); STOCK, Jürgen, 71254 Ditzingen (DE)
(86) Internationale Anmeldenummer: PCT/DE2003/003867
(87) Internationale Veröffentlichungsnummer: WO 2004/061990

(56) Entgegenhaltungen:
- US-A- 4 945 393
- US-A- 5 463 275
- US-A- 6 111 265
- PATENT ABSTRACTS OF JAPAN Bd. 0111, Nr. 90 (E-517), 18. Juni 1987 (1987-06-18) -& JP 62 020373 A (FUJITSU LTD), 28. Januar 1987 (1987-01-28)
- SPOONER H ET AL: "ADVANCES IN HOT ELECTRON INJECTOR GUNN DIODES" GEC JOURNAL OF RESEARCH, GEC MARCONI RESEARCH CENTER. GREAT BADDOW CHEMSFORD, GB, Bd. 7, Nr. 1, 1989, Seiten 34-45, XP000054098 ISSN: 0264-9187
- HUTCHINSON S ET AL: "Implant isolation scheme for current confinement in graded-gap Gunn diodes" ELECTRONICS LETTERS, IEE STEVENAGE, GB, Bd. 32, Nr. 9, 25. April 1996 (1996-04-25), Seiten 851-852, XP006005058 ISSN: 0013-5194 in der Anmeldung erwähnt

## Beschreibung

Die Erfindung betrifft eine Gunn-Diode.

Der Gunn-Effekt betrifft eine Erscheinung, bei der eine konstante, relativ hohe elektrische Feldstärke (elektrische Feldstärken über 2000V/cm) an einem n-dotierten Galliumarsenidkristall schnelle Stromschwankungen verursacht. Es zeigt sich, dass bei sehr kurzen Kristallen diese Stromfluktuationen in zusammenhängende Schwingungen übergehen, deren Frequenzen durch die Länge der Kristalle festgelegt sind und im Mikrowellenbereich liegen. Auch in anderen halbleitenden III-V-Verbindungen, wie z. B. n-dotiertem Indiumphosphid, entstehen infolge des Effektes Mikrowellen, wenn die elektrische Feldstärke in ihnen einen bei einigen tausend V/cm liegenden kritischen Wert überschreitet. Der Effekt tritt allgemein in III/V-Halbleitern auf, deren Energiebänder relative Maxima und Minima in einem nicht zu großen energetischen Abstand haben, so dass heiße Elektronen leicht in höherliegende Bänder gelangen. Haben sie dort eine kleinere Beweglichkeit, so gehört zur größeren Feldstärke eine kleinere Stromstärke, das heißt, es liegt ein negativer Widerstand vor, der Voraussetzung für eine Schwingungserzeugung und Verstärkung ist. Der Gunn-Effekt wird im sogenannten Gunn-Oszillator zur Mikrowellenerzeugung ausgenutzt.

Ab einer bestimmten Feldstärke entstehen somit an einem Elektronen-Emitter sogenannte spontane Dipoldomänen, die mit einer bestimmten Geschwindigkeit durch den Halbleiter laufen und an einem Kollektor enden. Erst wenn die Domäne am Kollektor angekommen ist, wird am Emitter eine weitere Domäne gebildet. Dem Emitter kommt somit entscheidende Bedeutung bei der Ausbildung der Domänen zu. Am Kollektor werden die Ladungsträger eingesammelt.

Eine Gunn-Diode kann typischerweise einen Emitter mit einer zum Kollektor gerichteten AlGaAs-Schicht aufweisen, die dazu dient einen Potentialsprung für die emittierenden Elektronen zu schaffen und sie somit energetisch relativ zur aktiven Diodenschicht anzuheben.

Aus der Druckschrift Greenwald et al. (Greenwald, Z. Woodard, D. W., Calawa, A.R., Eastman, L. F. (1988). The effect of a high energy injection on the performance of millimeter wafe gunn oscillators. Solid-State Electronics 31, 1211-1214) ist eine Gunn-Diode bekannt, welche eine Schichtenfolge mit einer AlGaAs-Schicht von konstantem Aluminium-Gehalt von 23 % aufweist.

Aus den Druckschriften US 4,801,982 sowie Hutchinson et al. (Hutchinson, S., J. Stephens, M. Carr and M. J, Kelly. Implant isolation scheme for current confinement in graded-gap Gunn diodes, IEEE Electronics Letters, 32(9), 851-852, 1996) ist bekannt, eine AlGaAs-Schicht mit veränderlichem, das heißt in Richtung des Kollektors, linear ansteigendem Aluminium-Gehalt von Null auf bis zu 30 % anzuordnen. Eine solche AlGaAs-Schicht wird im englischen Sprachgebrauch als graded layer, und im weiteren als gegradete Schicht bezeichnet. Die gegradete Schicht kann als stufenloser Übergang zu Aluminium-Gehalten hoher Konzentration ausgebildet sein. Hierdurch wird vorteilhaft unerwünschte Elektronenreflektion minimiert und Elektronen mit Energien passend zum Energieband mit niedrigerer Elektronenbeweglichkeit injiziert.

Die aus dem Stand der Technik bekannten Schichtenfolgen weisen bei hohen Herstellungs- und/oder Einsatztemperaturen der Gunn-Diode die nachteilige Eigenschaft auf, dass die gewollte Potentialbarriere der AlGaAs-Schicht unwirksam, das heißt elektrisch inaktiv ist. Dies wird insbesondere bei niedrigen Eingangsspannungen deutlich, da dann bereits ein linearer Anstieg des Stromes als Funktion der Spannung auftritt.

Aufgabe der Erfindung ist daher, eine Gunn-Diode bereit zu stellen, welche eine Strom-Spannungs-Kennlinie ohne die im Stand der Technik genannten Nachteile liefert.

Die Aufgabe wird durch eine Gunn-Diode gemäß Hauptanspruch und durch ein Verfahren gemäß Nebenanspruch gelöst. Vorteilhafte Ausgestaltungen ergeben sich aus den darauf rückbezogenen Patentansprüchen.
Die Gunn-Diode umfasst einen Emitter aus einer Abfolge aufeinander angeordneter Schichten mit einer ersten hochdotierten n_{d}-GaAs-Schicht und einer auf der ersten hochdotierten Schicht angeordneten gegradeten Schicht aus AlGaAs, wobei die Aluminium-Konzentration dieser Schicht von der Grenzfläche zur ersten n_{d}-GaAs-Schicht ausgehend in Richtung der gegenüberliegenden Grenzfläche der AlGaAs-Schicht abnimmt, und einer zweiten hochdotierten n⁺-Schicht. Die Gunn-Diode ist
dadurch gekennzeichnet, dass
an der Grenzfläche der AlGaAs-Schicht zu der hochdotierten n_{d}-GaAs-Schicht eine undotierte Zwischenschicht aus GaAs als Diffusions- bzw. Segregationsstopschicht für die Dotieratome der n_{d}-GaAs-schicht angeordnet ist. An der Grenzfläche der AlGaAs-Schicht zu der hochdotierten n_{d}-GaAs-Schicht ist somit eine undotierte Zwischenschicht aus GaAs angeordnet.

Die AlGaAs-Schicht und die hochdotierte n⁺-Schicht stellen funktional den Emitter einer Gunn-Diode bzw. eines Gunn-Oszillators dar. Die am Emitter angrenzende hochdotierte n_{d}-GaAs-Schicht dient der Feinabstimmung des Energieniveaus der Dipoldomänen, die in Richtung eines Kollektors erzeugt werden.

Die undotierte zwischenschicht besteht aus GaAs.
Eine solche Zwischenschicht bewirkt vorteilhaft, dass die Strom-Spannungs-Kennlinie ein ausgeprägtes nichtlineares Verhalten, das heißt Schottky-Typ-artiges Verhalten bei kleinen Spannungen aufweist.

Das Ausgangsmaterial der n⁺-dotierten, Elektronen emittierenden Schicht ist vorteilhaft ebenfalls GaAs.

In einer weiteren Ausgestaltung der Erfindung weist die AlGaAs-Schicht an beiden Grenzflächen zu den angrenzenden hochdotierten Schichten, das heißt sowohl zur angrenzenden n⁺-dotierten, Elektronen emittierenden Schicht als auch zur angrenzenden hochdotierten n_{d}-GaAs-Schicht, eine solche undotierte Zwischenschicht aus GaAs auf. Dadurch wird eine weitere Verbesserung der Strom-Spannungs-Kennlinie in der Weise erzielt, dass diese Schicht sowohl von der Emitterseite wie auch von der Kollektorseite der gegradeten Schicht eine definierte elektronische Struktur aufweist.

Eine solche Schichtenfolge dient als Ausgangsschichtenfolge für Gunn-Dioden und Gunn-Oszillatoren. Dann schließen sich an die hochdotierte n_{d}-GaAs-Schicht weitere Schichten für derartige elektronische Bauelemente an.
An das von der Elektronen emittierenden Schicht gegenüberliegende Ende der hochdotierten n_{d}-GaAs-Schicht, sind als solche weitere Schichten für derartige elektronische Bauelemente, insbesondere eine niedrig dotierte n⁻-GaAs-Schicht, als eigentliche den Gunn-Effekt bildende Schicht sowie eine hieran anschließende weitere hochdotierte n⁺-Schicht als Kollektor bildende Schicht vorgesehen. Die Kollektorschicht kann ebenfalls aus GaAs bestehen.

Als Dotierstoff für die Schichten kommt insbesondere Silizium aber auch Tellur in Frage. Diese Elemente bewirken vorteilhaft reine Elektronenleitfähigkeiten.

Ein Verfahren zur Herstellung einer derartigen erfindungsgemäßen Gunn-Diode umfasst den kennzeichnenden Schritt, dass während des Verfahrens an der Grenzfläche der AlGaAs-Schicht zu der hochdotierten n_{d}-GaAs-Schicht eine undotierte Zwischenschicht aus GaAs als Diffusions- bzw. Segregationsstopschicht für die Dotieratome der n_{d}-GaAs-Schicht angeordnet wird. Die Schicht wird sodann bei geeigneten Temperaturen epitaxiert. Auf der undotierten Zwischenschicht aus GaAs ist die AlGaAs-Schicht mit einer veränderlichen Aluminium-Konzentration angeordnet. Die Konzentration sinkt stufenlos ausgehend von der GaAs-Schicht von einem Höchstwert, z. B. 30 % bis auf Null % ab. Auf der AlGaAs-Schicht kann sodann eine weitere undotierte GaAs-Schicht oder aber direkt eine hochdotierte n⁺-Schicht angeordnet werden. Die zweite undotierte GaAs-Schicht ist also optional.

Es wird somit zumindest eine undotierte GaAs-Schicht an der Grenzfläche der AlGaAs-Schicht zu der hochdotierten n_{d}-GaAs=Schicht angeordnet und bei geeigneter Temperatur epitaxiert.

Optional kann an beiden Grenzflächen der AlGaAs-Schicht zu den hochdotierten Schichten eine GaAs-Schicht als Zwischenschicht aufgebracht und bei geeigneter Temperatur epitaxiert werden.
Das Verfahren bewirkt vorteilhaft, dass während der gewählten Temperaturen von ca. 600 °C, welche für das e-pitaktische Aufwachsen von GaAs-Schichten vorteilhaft sind, keine Dotieratome in die AlGaAs-Schicht eindiffundieren bzw. segregieren. Die AlGaAs-Schicht wird auf diese Weise vor Dotieratomen, z. B. Silizium oder Tellur geschützt. Diese GaAs-Schichten besitzen somit die Funktion von Diffusions- bzw. Segregationsstopschichten für angrenzende Dotieratome hochdotierter Bereiche in der Schichtenfolge. Eine GaAs-Schicht als Diffusions- bzw. Segregationsstopschicht der Gunn-Diode bewirkt, dass die Schichtenfolge unabhängig von der Temperatur hergestellt werden kann. Das hat zur Folge, dass die Schichtenfolge bei einer für GaAs idealen Wachstumstemperatur von ca. 600°C hergestellt werden kann. Dies hat zusätzlich den Vorteil, dass mögliche sehr starke Erhitzungen des Bauelementes auch nach der Fertigstellung und während der Herstellung zu keiner temperaturabhängigen Degradation des Bauelementes führen.

Im Folgenden wird die Erfindung an Hand zweier Ausführungsbeispiele und der beigefügten Figuren näher erläutert.

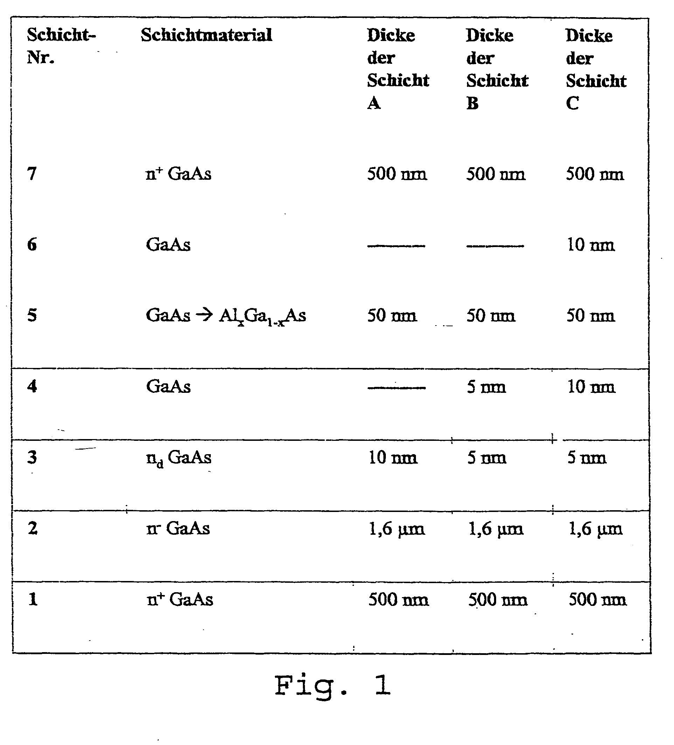

Figur 1 zeigt in der Übersicht drei Schichtenfolgen
A-C, mit gar keiner (Schichtenfolge A: Stand der Technik) einer (Schichtenfolge B) und zwei zusätzlichen (Schichtenfolge C) GaAs-Schichten als Diffusions- bzw. Segregationsstopschichten 4, 6 für eine AlGaAs-Schicht 5 als gegradete Schicht. Das Material der einzelnen Schichten der Schichtenfolgen ist jeweils identisch, kann in der Dicke aber variieren, wie in Spalten A-C angegeben.

In den Schichtenfolgen A-C stellt die hochdotierte n⁺ GaAs-Schicht 1 jeweils einen Kollektor als elektrische Zuleitung der Gunn-Diode dar.

Der Kollektor 1, als elektrische Zuleitung, ist als hochdotierte n⁺-GaAs-Schicht mit 4*10¹⁸ cm⁻³ Silizium dotiert. Hierauf ist eine den Gunn-Effekt ausübende n⁻-GaAs-Schicht 2 mit niedriger Silizium Dotierung (11¹⁶ cm⁻³ silizium) als sogenannte 'transit zone' angeordnet. Gegenüberliegend zum Kollektor 1 ist auf Schicht 2 eine n_{d}-GaAs-Schicht angeordnet. Die Dotierung dieser Schicht 3 mit Silizium liegt bei 4*10¹⁸ cm⁻³ für Schichtenfolge A, und jeweils 10¹⁸ cm⁻³ für Schichtenfolge B und C. Auf der 10 Nanometer dicken hochdotierten n_{d}-GaAs-Schicht 3, ist eine 50 Nanometer dicke AlGaAs-Schicht 5 aufgebracht, die an der Grenzfläche zur hochdotierten n_{d}-GaAs-Schicht 3 eine Aluminium-Konzentration von 30 % aufweist, welche dann stufenlos bis auf Null % abnimmt. Im Falle der Schichtenfolge C wurde eine maximale Aluminium-Konzentration von 32 % in der Schicht 5 gewählt. Auf der AlGaAs-Schicht 5 ist die hochdotierte n⁺-GaAs-Schicht 7 angeordnet, die mit 4*10¹⁸ cm⁻³ Silizium dotiert wurde.

Zwischen der n_{d}-GaAs-Schicht 3 und der AlGaAs-Schicht 5 ist bei den Schichtenfolgen B und C zusätzlich eine undotierte GaAs-Schicht 4 als Diffusions- bzw. Segregationsstopschicht angeordnet. Diese Schicht ist im Falle der Schichtenfolge B fünf Nanometer dick. In der Schichtenfolge C ist diese Schicht zehn Nanometer dick. zusätzlich ist auf der AlGaAs-Schicht 5 in der Schichtenfolge C eine weitere zehn Nanometer dicke undotierte GaAs-Schicht 6 auf der AlGaAs-Schicht 6 angeordnet.

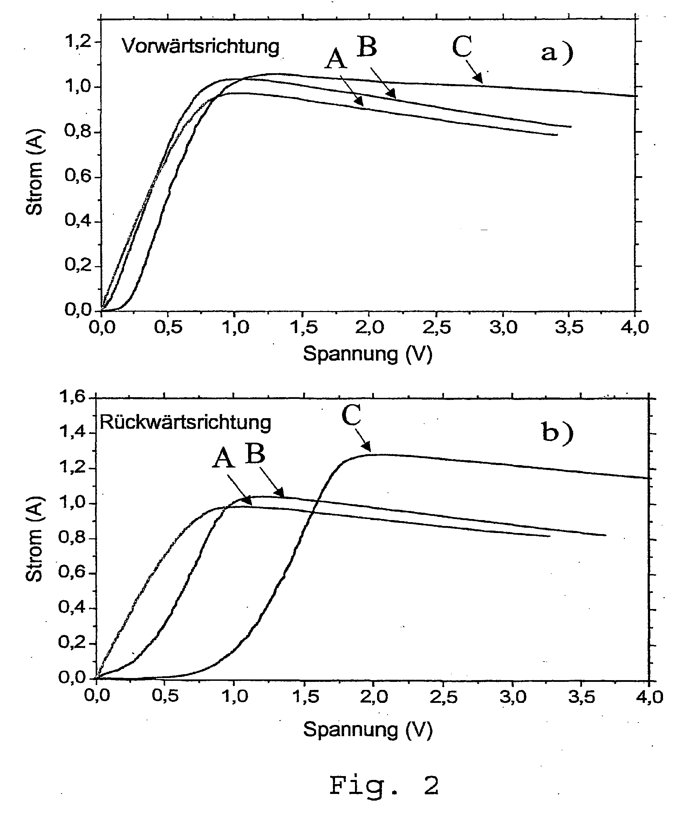

Figur 2 zeigt im Vergleich die I-U Kennlinien der Schichtenfolgen A-C in Vorwärts- bzw. Rückwärts Richtung.

Die I-U Kennlinie der Schichtenfolge A, abgeschieden bei einer für GaAs idealen Wachstumstemperatur von 600°C, zeigt keinen Schottky-typischen Anstieg in der I-U Kennlinie. Die Kurve beginnt vielmehr mit einer Geraden, was das Verhalten eines ohmschen Widerstandes andeutet. Die Kurve zeigt darüber hinaus ein symmetrisches Verhalten für positive und negative Versorgungsspannungen.

Das Einbringen einer Diffusions- bzw. Segregationsstopschicht 4 unterhalb der gegradeten AlGaAs-Schicht 5 in schichtenfolge B hingegen zeigt bereits eine deutliche Verbesserung der Kennlinie in Bezug auf Nichtlinearität, und damit eine gute Funktionsweise der AlGaAs-Schicht. Es ist deutlich sowohl in Hin- wie auch in Rückrichtung eine Schottky-typ-artige Kennlinie zu erkennen.

Noch ausgeprägter ist das Verhalten, wenn auf der gegradeten AlGaAs-Schicht 5 eine weitere Diffusions- bzw. Segregationsstopschicht 6 (Schichtenfolge C) angeordnet ist und eine. Eindiffusion von Dotieratomen aus hochdotierten Bereichen in die AlGaAs-Schicht 5 an beiden Grenzflächen zu hochdotierten Schichten unterbunden wird. Dann ist eine sehr ausgeprägte Schottky-typ-artige Kennlinie zu erkennen (Kurve C, Fig. 2).

Während die Kennlinie für die Schichtenfolge C deutlich die Wirkung eines gegradeten Emitters zeigt, erkennt man genauso deutlich die Wirkungslosigkeit der AlGaAs-Schicht bei Kurve A. Dieser Effekt beruht auf der Diffusion bzw. Segregation des Dotierstoffs Silizium von Schicht 7 bzw. 3 in die AlGaAs-Schcht 5 und bewirkt, dass die Schicht 5 elektrisch dotiert und in Ihrer Wirkung verändert wird.

Es ist im Rahmen der Erfindung denkbar, eine erfindungsgemäße Schichtenfolge für weitere elektronische Bauelemente, die als Injektionsschicht eine Potentialbarriere benötigen, zu verwenden.

Es sind weitere Schichtenfolgen denkbar, bei denen das Prinzip einen graded layer durch undotierte Zwischenschichten als Diffusions- bzw. Segregationsstopschichten zu schützen, angewendet werden kann, beispielsweise eine auf InP basierende Schichtenfolge. Bei dieser Schichtenfolge wäre an Stelle von GaAs als Material der Schichten 1 bis 7 InP eingesetzt.

## Patentansprüche

1. Gunn-Diode, umfassend einen Emitter aus einer Abfolge aufeinander angeordneter Schichten mit einer ersten hochdotierten n_{d}-GaAs-Schicht (3) und einer auf der ersten hochdotierten Schicht (3) angeordneten gegradeten Schicht aus AlGaAs (5), wobei die Aluminium-Konzentration dieser Schicht (5) von der Grenzfläche zur ersten n_{d}-GaAs-Schicht (3) ausgehend in Richtung der gegenüberliegenden Grenzfläche der AlGaAs-Schicht (5) abnimmt, und einer zweiten hochdotierten n⁺-Schicht (7),
**dadurch gekennzeichnet, dass**
an der Grenzfläche der AlGaAs-Schicht (5) zu der hochdotierten n_{d}-GaAs-Schicht (3) eine undotierte Zwischenschicht aus GaAs (4) als Diffusions- bzw. Segregationsstopschicht für die Dotieratome der n_{d}-GaAs-Schicht (3) angeordnet ist.

2. Gunn-Diode nach Anspruch 1,
**gekennzeichnet durch**
GaAs als Material für die hochdotierte n⁺-Schicht (7).

3. Gunn-Diode nach einem der vorhergehenden Ansprüche,
**gekennzeichnet durch**
Silizium oder Tellur als Dotierstoff.

4. Gunn-Diode nach einem der vorhergehenden Ansprüche,
**dadurch gekennzeichnet, dass**
die erste hochdotierte n_{d}-GaAs-Schicht (3) und/oder die zweite hochdotierte n⁺-Schicht (7) mit bis zu 10¹⁸ cm⁻³ Silizium dotiert sind.

5. Gunn-Diode nach einem der vorhergehenden Ansprüche 1-4,
**dadurch gekennzeichnet, dass**
eine weitere undotierte GaAs-Schicht (6) zwischen der AlGaAs-Schicht (5) und der zweiten hochdotierten n⁺-GaAs-Schicht (7) angeordnet ist.

6. Gunn-Diode nach einem der vorhergehenden Ansprüche,
**dadurch gekennzeichnet, dass**
die Schichtenfolge (3, 4, 5, 6, 7) auf weiteren Schichten (1, 2) angeordnet ist.

7. Gunn-Diode nach einem der vorhergehenden Ansprüche,
**dadurch gekennzeichnet, dass**
die Schichtenfolge (3, 4, 5, 6, 7) auf einer n⁻-GaAs-Schicht (2) angeordnet ist.

8. Gunn-Diode nach vorhergehendem Anspruch,
**dadurch gekennzeichnet, dass**
die n⁻-GaAs-Schicht (2) auf einer hochdotierten n⁺-Schicht (1), insbesondere aus GaAs angeordnet ist.

9. Verfahren zur Herstellung einer Gunn-Diode, umfassend einen Emitter aus einer Abfolge aufeinander angeordneter Schichten mit einer ersten hochdotierten n_{d}-GaAs-Schicht (3) und einer auf der ersten hochdotierten Schicht (3) angeordneten gegradeten Schicht aus AlGaAs (5), wobei die Aluminium-Konzentration dieser Schicht (5) von der Grenzfläche zur ersten n_{d}-GaAs-Schicht (3) ausgehend in Richtung der gegenüberliegenden Grenzfläche der AlGaAs-Schicht (5) abnimmt, und einer zweiten hochdotierten n⁺-Schicht (7),
**dadurch gekennzeichnet, dass**
während des Verfahrens zur Herstellung der Gunn-Diode an der Grenzfläche der AlGaAs-Schicht (5) zu der hochdotierten n_{d}-GaAs-Schicht (3) eine undotierte Zwischenschicht aus GaAs (4) als Diffusions- bzw. Segregationsstopschicht für die Dotieratome der n_{d}-GaAs-Schicht (3) angeordnet wird.

10. Verfahren nach Anspruch 9,
**dadurch gekennzeichnet, dass**
auch an der Grenzfläche der AlGaAs-Schicht (5) zur zweiten hochdotierten n⁺-Schicht (7) eine undotierte GaAs-Schicht (6) angeordnet wird.

## Claims

1. Gunn diode, comprising an emitter consisting of a series of layers arranged stacked on top of each other with a first highly doped n_{d} GaAs layer (3) and a graded AlGaAs layer (5) arranged on the first highly doped layer (3), in which the aluminium concentration of this layer (5) decreases starting from the boundary surface in relation to the first n_{d} GaAs layer (3) in the direction of the opposite boundary surface of the AlGaAs layer (5) and of a second highly doped n⁺ layer (7),
**characterised in that**
an undoped intermediate GaAs layer (4) is arranged on the boundary surface of the AlGaAs layer (5) in relation to the highly doped n_{d} GaAs layer (3) to act as a diffusion or segregation barrier layer for the doping atoms of the n_{d} GaAs layer (3).

2. Gunn diode according to claim 1,
**characterised by**
GaAs being the material for the highly doped n⁺ layer (7).

3. Gunn diode according to one of the foregoing claims,
**characterised by**
silicon or tellurium being the dopant.

4. Gunn diode according to one of the foregoing claims,
**characterised in that**
the first highly doped n_{d} GaAs layer (3) and / or the second highly doped n⁺ layer (7) is doped with up to 10¹⁸ cm⁻³ of silicon.

5. Gunn diode according to one of the foregoing claims 1-4,
**characterised in that**
a further undoped GaAs layer (6) is arranged between the AlGaAs layer (5) and the second highly doped n⁺ GaAs layer (7).

6. Gunn diode according to one of the foregoing claims,
**characterised in that**
the series of layers (3, 4, 5, 6, 7) is arranged on further layers (1, 2).

7. Gunn diode according to one of the foregoing claims,
**characterised in that**
the series of layers (3, 4, 5, 6, 7) is arranged on an n⁻ GaAs layer (2).

8. Gunn diode according to the foregoing claim,
**characterised in that**
the n- GaAs layer (2) is arranged on a highly doped n⁺ layer (1), particularly such a GaAs layer.

9. Procedure for producing a gunn diode, comprising an emitter consisting of a series of layers arranged stacked on top of each other with a first highly doped n_{d} GaAs layer (3) and a graded AlGaAs layer (5) arranged on the first highly doped layer (3), in which the aluminium concentration of this layer (5) decreases starting from the boundary surface in relation to the first n_{d} GaAs layer (3) in the direction of the opposite boundary surface of the AlGaAs layer (5) and of a second highly doped n⁺ layer (7),
**characterised in that**
during the procedure for producing the gunn diode an undoped intermediate GaAs layer (4) is arranged on the boundary surface of the AlGaAs layer (5) in relation to the highly doped n_{d} GaAs layer (3) to act as a diffusion or segregation barrier layer for the doping atoms of the n_{d} GaAs layer (3).

10. Procedure according to claim 9,
**characterised in that**
an undoped GaAs layer (6) is also arranged on the boundary surface of the AlGaAs layer (5) in relation to the second highly doped n⁺ layer (7).

## Revendications

1. Diode Gunn, comprenant un émetteur composé d'une succession de couches disposées les unes sur les autres et ayant une première couche (3) en GaAs-n_{d} très dopée et une couche en AlGaAs (5) graduée, disposée sur la première couche (3) très dopée, la concentration d'aluminium de cette couche (5) diminuant en partant de l'interface avec la première couche (3) en GaAs-n_{d} en direction de l'interface opposée de la couche (5) d'AlGaAs, et une deuxième couche (7) n⁺ très dopée,
**caractérisée en ce que**
à l'interface de la couche (5) d' AlGaAs avec la couche (3) en GaAs-n_{d} très dopée est disposée une couche intermédiaire non dopée en GaAs (4) en tant que couche d'arrêt de diffusion et de ségrégation pour les atomes de dopage de la couche (3) en GaAs-n_{d}.

2. Diode Gunn suivant la revendication 1,
**caractérisée par**
du GaAs comme matériau pour la couche (7) n⁺ très dopée.

3. Diode Gunn suivant l'une des revendications précédentes,
**caractérisée par**
du silicium ou du tellure comme substance de dopage.

4. Diode Gunn suivant l'une des revendications précédentes,
**caractérisée en ce que**
la première couche (3) en GaAs-n_{d} très dopée et/ou la deuxième couche (7) n⁺ très dopée sont dopées par jusqu'à 10¹⁸ cm⁻³ de silicium.

5. Diode Gunn suivant l'une des revendications précédentes 1 à 4
**caractérisée en ce que**
il est disposé une autre couche (6) en GaAs non dopée entre la couche (5) en AlGaAs et la deuxième couche (7) en GaAs-n⁺ très dopée.

6. Diode Gunn suivant l'une des revendications précédentes,
**caractérisée en ce que**
la succession (3, 4, 5, 6, 7) de couches est disposée sur d'autres couches (1, 2).

7. Diode Gunn suivant l'une des revendications précédentes,
**caractérisée en ce que**
la succession (3, 4, 5, 6, 7) de couches est disposée sur une couche (2) en GaAs-n⁻.

8. Diode Gunn suivant la revendication précédente,
**caractérisée en ce que**
la couche (2) en GaAs-n⁻ est disposée sur une couche (1) n⁺ très dopée, notamment en GaAs.

9. Procédé de production d'une diode Gunn, comprenant un émetteur composé d'une succession de couches disposées les unes sur les autres et ayant une première couche (3) en GaAs-n_{d} très dopée et une couche en AlGaAs (5) graduée, disposée sur la première couche (3) très dopée, la concentration d'aluminium de cette couche (5) diminuant en partant de l'interface avec la première couche (3) en GaAs-n_{d} en direction de l'interface opposée de la couche (5) d'AlGaAs, et une deuxième couche (7) n⁺ très dopée,
**caractérisé en ce que**
pendant le procédé de production de la diode Gunn, on dispose à l'interface de la couche (5) en AlGaAs avec la couche (3) en GaAs-n_{d} très dopée une couche intermédiaire non dopée en GaAs (4) en tant que couche d'arrêt de diffusion et de ségrégation des atomes de dopage de la couche (3) en GaAs-n_{d}.

10. Procédé suivant la revendication 9,
**caractérisé en ce que**
on dispose aussi sur l'interface de la couche (5) en AlGaAs avec la deuxième couche (7) n⁺ très dopée une couche (6) en GaAs non dopée.
